(19) Europäisches Patentamt
European Patent Office
Office européen des brevets

(11) Publication number : **0 622 801 A2**

# (12) EUROPEAN PATENT APPLICATION

(21) Application number : **94302350.7**

(51) Int. Cl.$^{5}$ : **G11C 7/00**

(22) Date of filing : **31.03.94**

(30) Priority : **31.03.93 US 40664**
**31.03.93 US 40666**

(43) Date of publication of application :
**02.11.94 Bulletin 94/44**

(84) Designated Contracting States :
**DE FR GB IT**

(71) Applicant : **SGS-THOMSON MICROELECTRONICS, INC.**
**1310 Electronics Drive**
**Carrollton Texas 75006 (US)**

(72) Inventor : **McClure, David Charles**
**3701 Elizabeth Drive**
**Carrollton, Texas 75007 (US)**

(74) Representative : **Palmer, Roger et al**
**PAGE, WHITE & FARRER**
**54 Doughty Street**
**London WC1N 2LS (GB)**

## (54) Hierarchical bitline memory architecture.

(57) In a high density memory, such as a SRAM, DRAM, EPROM or EEPROM, a hierarchical bitline configuration is utilized such that a number of local bitlines are connected to a master bitline through interface circuitry which connects a local bitline to the master bitline. Local select signals, when set to the appropriate voltage level, couple a local bitline to the master bitline. In addition to reducing the local bitline capacitance that must be driven by memory cells, the hierarchical configuration may provide layout area savings as well.

Interface circuitry is modified to provide voltage and signal gain and/or provide isolation between the local bitlines and the master bitlines, thereby reducing the amount of capacitance which must be driven by memory cells and the amount of time required to develop differential signals on the master bitlines.

20
22
24
26
28
32
34
36
38
40
30
50
52

FIG. 2



Jouve, 18, rue Saint-Denis, 75001 PARIS

The present invention relates generally to integrated circuits, including hierarchical bitline memory architecture and interface circuitry within the hierarchical bitline memory architecture which provides gain and/or isolation characteristics.

In recent years, high density memories such as SRAMs, DRAMs, EPROMs, and EEPROMs have dramatically increased the level of bitline capacitance which must be driven by memory cells in the memory array. As high speed memories have increased in density, efforts have been made to carefully partition the memory array to reduce the burden on the memory cell for driving large bitline capacitances. For example, memory arrays have gone to four times the number of columns as rows to reduce bitline capacitance. In addition, the rows are sometimes bisected by the sensing and column decode circuitry to further reduce bitline capacitance. In spite of the advances made in careful partitioning of the memory array, bitline capacitance can still be prohibitively large, having an adverse affect on device speed and signal integrity. As a result, better methods for reducing the bitline capacitance as seen by memory cells while using minimum layout area are needed and appropriate.

In a high density memory, such as a SRAM, DRAM, EPROM or EEPROM, a hierarchical bitline configuration is utilized such that a number of local bitlines are connected to a master bitline through interface circuitry which connects a local bitline to the master bitline. Local select signals, when set to the appropriate voltage level, couple a local bitline to the master bitline. In addition to reducing the local bitline capacitance that must be driven by memory cells, the hierarchical configuration may provide layout area savings as well.

Interface circuitry is modified to provide voltage and signal gain and/or provide isolation between the local bitlines and the master bitlines, thereby reducing the amount of capacitance which must be driven by memory cells and the amount of time required to develop differential signals on the master bitlines.

According to a preferred embodiment of the present invention there is provided a partitioned memory array, comprising a plurality of master bitlines, a plurality of local bitlines connected to a plurality of memory cells, a plurality of interface circuits, which connects each master bitline to at least two of the local bitlines, and a plurality of local select signals, each capable of selecting a corresponding local bitline to be coupled to its corresponding master bitline.

The interface circuitry may be comprised of an n-channel transistor.

Preferably the gate of the n-channel transistor is connected to a local select signal.

Preferably the local select signals are bootstrapped above a first supply voltage.

Preferably the first supply voltage is $V_{cc}$.

Preferably the n-channel transistor has a lower $V_T$ such that the voltage drop across it is minimized.

Preferably the well in which the n-channel transistor resides is pumped to a lower voltage which is less than a second supply voltage.

Preferably the second supply voltage is $V_{ss}$.

The interface circuitry may be comprised of a full CMOS transmission gate having an n-channel transistor and a p-channel transistor.

Preferably the gate of the n-channel transistor is connected to a local select signal and the gate of the p-channel transistor is connected to the complement of the local select signal.

Each local bitline may be connected to a loading element such that it is tied to a predetermined voltage level.

The loading element may be a high value resistor.

Preferably the high value resistor is formed in a polysilicon layer.

Preferably the high value resistor is formed in an active diffusion region.

The loading element may be a pullup transistor.

The memory array may be formed using a first metal layer, a second metal layer, and a third metal layer.

The master bitlines may be formed on top of the local bitlines.

The master bitlines may be formed at an offset from the local bitlines.

A metal layer which contains the master bitlines may be above a metal layer which contains the local bitlines.

The master bitlines may reside in the third metal layer and the local bitlines reside in the second metal layer.

The master bitlines may reside in the second metal layer and the local bitlines reside in the first metal layer.

The partitioned memory array may be suitable for use in SRAM, DRAM, EPROM and EEPROM memories.

Preferably the memory array is an SRAM and each local bitline is a local bitline pair and the master bitline is a master bitline pair.

Preferably a 4 Megabit SRAM is comprised of four local bitline pairs connected to a master bitline pair, each bitline pair having 128 memory cells.

Preferably the local bitlines may be recovered when its local select signal is selected while its corresponding master bitline is being recovered.

Preferably each local bitline has an equilibrate device which is controlled by an equilibration signal.

Preferably the equilibration signal is decoded based on its corresponding local select signal.

Preferably each local bitline has a precharge device which is controlled by a precharge signal.

Preferably the precharge signal is decoded based on its corresponding local select signal.

According to a second preferred embodiment of the present invention there is provided a partitioned memory array, comprising a plurality of master bitlines, a plurality of local bitlines connected to a plurality of memory cells, a plurality of interface circuits, which connects each master bitline to at least two of the local bitlines and which provides for gain of a signal on the local bitlines or isolation of the capacitance of the local bitlines from the capacitance of the master bitlines, and a plurality of local select signals, each capable of selecting a corresponding local bitline to be coupled to its corresponding master bitline.

The local bitline may be connected to the master bitline through at least one select transistor and isolation of the capacitance of the local bitlines from the capacitance of the master bitlines is provided by at least one source-follower transistor.

The source of an n-channel select transistor may be connected to the master bitline, the gate is connected to a corresponding local select signal, and the drain is connected to an n-channel source follower transistor whose drain is connected to a supply voltage and whose gate is connected to the local bitline.

Preferably the supply voltage is $V_{cc}$.

The drain of a p-channel select transistor may be connected to the master bitline, the gate is connected to a corresponding local select signal, and the source is connected to an n-channel source follower transistor whose drain is connected to a supply voltage and whose gate is connected to the local bitline.

Preferably at least two local bitlines share a select transistor.

The gate of the source follower transistor may be controlled by a pull-down transistor to ground and a pass gate which in turn is controlled by the local select signal, such that if the pass gate is not on, the source follower transistor is turned off, and if the pass gate is on, the source follower transistor is turned on.

Preferably a first local bitline and a second local bitline share a source follower transistor.

A first local bitline and a second local bitline may share a local select signal which provides a path to ground, with each local bitline having a transistor as its interface circuit.

Preferably the first local bitline and the second local bitline form a local bitline pair.

Preferably the transistors may be connected to one another serially or in parallel.

Preferably a local bitline is selected when its corresponding local select signal is set to a first voltage level and is not selected when its corresponding local select signal is set to a second voltage level.

Preferably the first voltage level is a logic high and the second voltage level is a logic low.

The local bitline signal may be amplified through source follower transistors.

The voltage level of the local bitline signal may be amplified.

The current level of the local bitline signal may be amplified.

The interface circuit may provide for the current differential of a selected memory cell to be amplified.

Preferably the current differential of a selected memory cell is amplified by a plurality of source follower transistors.

Preferably the current differential on a master bitline which is caused by source follower transistors is due to the resultant voltage differential on a corresponding local bitline when a memory cell is selected.

A cascode current sense amp may provide a virtual short across a local bitline pair, having a first local bitline and a second local bitline, such that the first local bitline and the second local bitline operate at the same voltage potential.

The first local bitline and the second local bitline may each have a first p-channel transistor whose gate is cross-coupled to the other local bitline and whose drain is connected to the source of a second p-channel transistor whose gate is connected to the local select signal and whose drain is connected to the master bitline.

The interface circuit of a local bitline which is not selected to be coupled to its corresponding master bitline may act as a load device for its corresponding master bitline.

Local bitline capacitance may be isolated from master bitline capacitance by clocking the source of a plurality of corresponding select transistors with the corresponding local select signal.

The source of a p-channel select transistor may be clocked by a local select signal, the gate is connected to the local bitline, and the drain is connected to the master bitline.

Isolation between a local bitline and a master bitline may be provided by a corresponding local select signal which is clocked to ground and acts as a current source when the local bitline is selected.

The gate of a transistor may be connected to the local bitline, the drain is connected to the master bitline and the source is connected to the local select signal.

Preferably at least two local bitlines share a dynamic sense amp, share a local select signal which clocks the dynamic sense amp, with each local bitline having an isolate signal to isolate the capacitance of the local bitline from the capacitance of the master bitline, and wherein the dynamic sense amp controls transistors connected to the master bitline.

Preferably when the isolate signal is a first predetermined voltage level, the local bitline is isolated, and when the isolate signal is a second predetermined voltage level, the local bitline is not isolated.

Preferably the first predetermined voltage level is $V_{cc}$ and the second predetermined voltage level is 0 volts.

The interface circuit by which a local bitline is connected to its corresponding master bitline may have an n-channel pass gate.

Preferably the n-channel pass gate is driven by a write local select signal such that the pass gate conducts only during a write cycle.

During a write cycle, an inverter connected to a master bitline may cause a local bitline to be pulled to a predetermined voltage if its corresponding master bitline is at the predetermined voltage when the local bitline is selected.

The master bitlines may each have a load device which is connected to a supply voltage.

Preferably the load device is controlled by a column decode signal.

Preferably a bias signal controlled by the column decode signal controls the load device such that only selected columns draw current.

Preferably a master bitline pair has a first master bitline and a second master bitline each of which has a transistor as its load device, wherein the gate of the first master bitline transistor is connected to the second master bitline and the gate of the second master bitline transistor is connected to the first master bitline.

Preferably the first master bitline and the second master bitline are connected to the load device which in turn is connected to a transistor which is controlled by a column decode signal and connected to a supply voltage.

Preferably the supply voltage is one of ground or $V_{cc}$.

The novel features believed characteristic of the invention are set forth in the appended claims. The invention itself however, as well as a preferred mode of use, and further objects and advantages thereof, will best be understood by reference to the following detailed description of an illustrative embodiment when read in conjunction with the accompanying drawings, wherein:

Figure 1 is a block diagram of a partitioned memory array according to the prior art;

Figure 2 is a schematic diagram of a portion of a partitioned memory array according to the present invention;

Figure 3a is a schematic diagram of a full CMOS transmission gate utilized as interface circuitry according to a first preferred embodiment of the present invention;

Figure 3b is a schematic diagram of an n-channel transistor utilized as interface circuitry according to a second preferred embodiment of the present invention;

Figure 4 is a schematic diagram of a partitioned memory array having interface circuitry and local bitline resistors, according to the present invention;

Figures 5 - 18 are schematic diagrams illustrating alternate preferred embodiments of interface circuitry, and master bitline loading devices, necessary for performing a read, according to the present invention; and

Figures 19 and 20 are schematic diagrams illustrating alternate preferred embodiments of interface circuitry necessary for performing a write, according to the present invention.

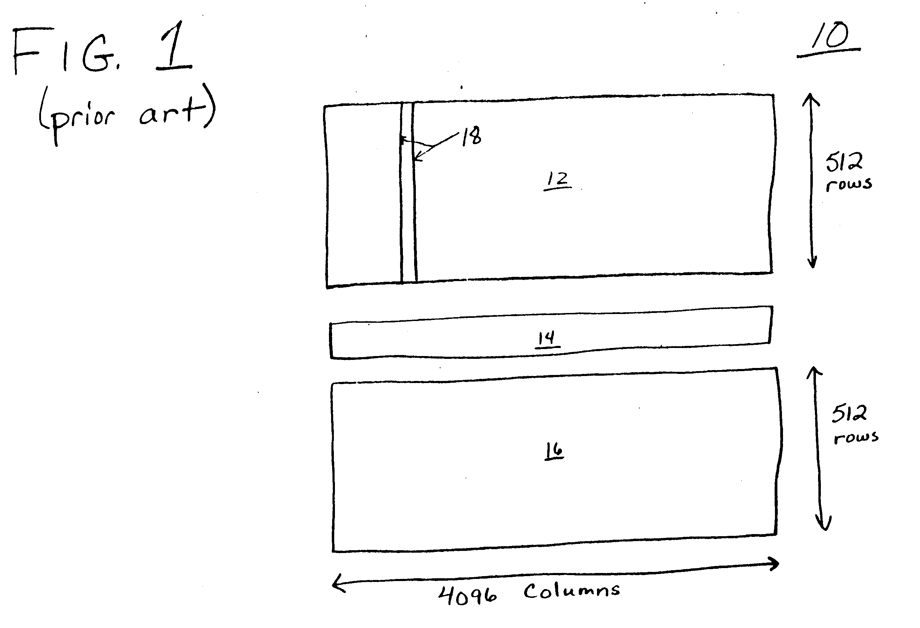

Referring to **Figure 1**, a block diagram of a partitioned memory array 10 according to the prior art is shown. As high speed memories, such as SRAMs, have become larger in density, there has been considerable emphasis placed on careful partitioning of the memory array to reduce the capacitance of bitline pairs, such as might be introduced by bitline pair 18, which must be driven by memory cells in the array.

As a result of this emphasis, memory array partitioning has increased in size and complexity. For example, memory arrays have increased the number of columns to four times the number of rows in an effort to reduce bitline capacitance. This is shown in **Figure 1** where there are 4096 columns to 1024 rows, a configuration which is representative of a 4 Megabit SRAM. Also illustrated is the bisection of rows by column decoding and sense amp circuitry 14 into two row sections 12 and 16, each having 512 rows. While this methodology does yield a decrease in bitline capacitance, it may not be sufficient for memories of very high density and/or high speed.

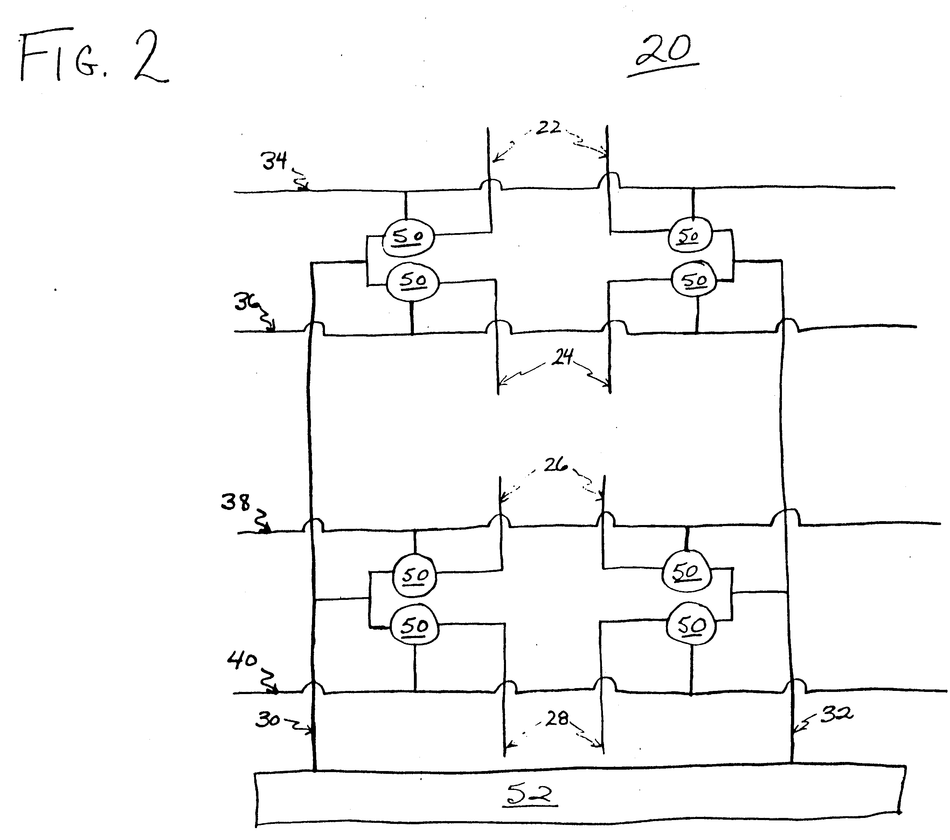

Referring now to **Figure 2**, a schematic diagram of a portion of a partitioned memory array 20 according to the present invention is shown. A hierarchical bitline configuration is employed, whereby local bitline pairs, such as 22, 24, 26, and 28 are connected to master bitline 30 and its complement, $\overline{\text{master bitline}}$ 32. Local bitline pairs are composed of two bitlines which are the complement of each other, as is well understood in the art. Likewise, master bitline 30 and $\overline{\text{master bitline}}$ 32 together form a master bitline pair.

Continuing with the 4 Megabit SRAM example, the 512 cell bitline of **Figure 1** is divided into four local bitline pairs 22, 24, 26, and 28 of 128 cells each. Each local bitline pair is separated from the other three local bitline pairs by interface circuitry 50 which is passive circuitry that connects a local bitline to master bitline 30 and $\overline{\text{master bitline}}$ 32. Local select signals 34, 36, 38, and 40 each couple an associated local bitline to master bitline 30 and $\overline{\text{master bitline}}$ 32. For example, local select signal 34 couples its local bitline 22 to master bitline 30 and 32.

As discussed above, a long bitline pair has been divided into four local bitline pairs; however, it is valid to break the bitline into any number of local bitline pair segments. The tradeoff to be considered is that while a larger number of segments would yield less capacitance and thus faster signal development, this would be done at the expense of additional layout area being consumed by an increased number of interface circuitry 50 and increased loading on the master bitline.

However, if traditional architecture having an equal number of rows as columns is used and column decoding and sense amp circuitry 14 as shown in **Figure 1** is placed at the edge of the memory array, then utilization of hierarchical architecture having master and local bitlines can result in layout area savings. This technique will utilize a smaller die than the prior art memory array of **Figure 1** and will result in equal or better performance as measured by decreased bitline capacitance. The use of master bitlines allows for a smaller memory die even if the performance is the same.

For high density memories, three metal layers may be utilized to achieve layout savings and to render local and master bitlines and wordline control. For example, it may be desirable to place master wordlines and sub-master wordlines in the first metal layer M1, local bitlines in M2, and master bitlines in M3. Master bitlines can be placed on top of local bitlines or at an offset from local bitlines such that layout area is conserved and local bitline capacitance is reduced. A master bitline in M3 could be placed directly on top of its associated local bitline which resides in M2. The master bitline capacitance is primarily bussing capacitance of the highest level conductor, in this case M3, with virtually no junction capacitance except at interface circuitry 50. Therefore, if the master bitline 30 and $\overline{\text{master bitline}}$ 32 are placed over the local bitline, up to one-third of the bus would couple to itself; it is not necessary for the master bitline pair to be placed over the first local bitline pair 22 if sensing circuitry and master bitline control 52 is situated at the bottom as shown in **Figure 2**. The bitline capacitance that a memory cell must drive is reduced by as much as one-fourth the typical capacitance of the prior-art.

Due to the relative newness of a third metal layer, pitch control may not be as readily available for the third metal layer as for the first and second metal layers. Since master and sub-master wordlines typically do not require as much pitch control as master and local bitlines, an alternate utilization of metal layers is to place local bitlines in M1, master bitlines in M2 and master and sub-master wordlines in M3. This arrangement of metal layers may make the manufacturing process easier to control.

Local bitlines which are not selected by their respective local select signals should not be allowed to float at an undetermined voltage level for an indefinite period of time. A bitline pull-up transistor may be placed on each local bitline, but this solution requires a good amount of layout area, area which would be desirable to conserve as much as possible. As an alternative, a high value resistor may be formed in polysilicon 1, 2, or 3 layers, or in the active diffusion region to serve as a maintaining current source at the chosen voltage level, typically $V_{cc}$ or $V_{cc}$ - $V_T$. High value resistors in the local bitlines may greatly reduce the layout area required for high density devices and prevent local bitlines from floating at undetermined voltage levels. Similarly, the master bitline may also have its own load device for facilitating read and write operations, whereby writing is performed using conventional methods and sensing may be accomplished using conventional voltage or current sensing techniques.

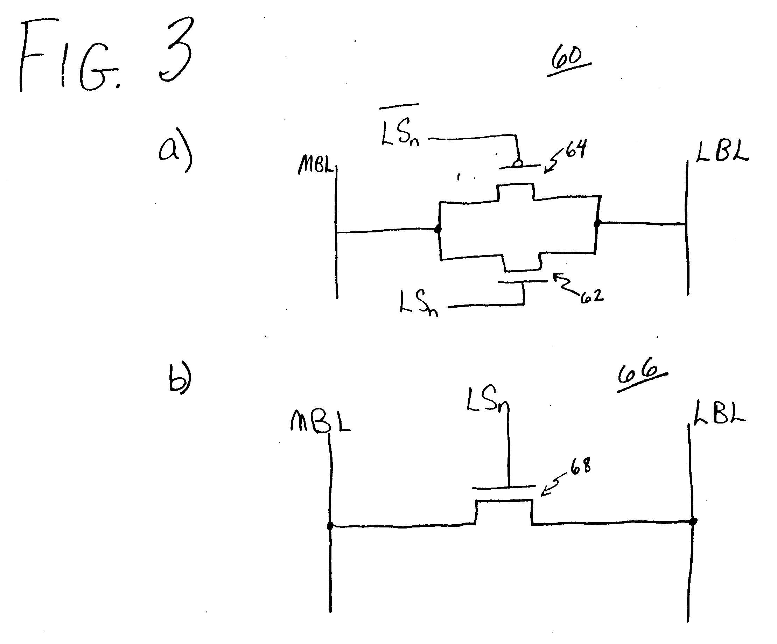

Interface circuity 50 may be implemented a variety of ways but it must allow the reading and writing of memory cells. Referring to Figures 3a and 3b, a schematic diagram of a full CMOS transmission gate and an n-channel transistor, respectively, are illustrated as interface circuitry according to a first and a second preferred embodiment of the present invention. The full CMOS transmission gate of Figure 3a has an n-channel transistor 62 and a p-channel transistor 64 which together connect the master bitline (MBL) to the local bitline (LBL). The gate of an n-channel transistor 62 is connected to local select signal LS, while the gate of p-channel transistor 64 is connected to the complement of the local select signal, $LS_n$. An advantage of CMOS transmission gate 60 is the ease of reading and writing of memory cells it provides, especially when the LBL is biased at the supply voltage, usually $V_{cc}$. On the other hand, since CMOS transmission gate 60 is composed of two transistors, more layout area is required than if only a single transistor were used.

Figure 3b shows a second preferred embodiment of interface circuitry 66, using only a single n-channel transistor 68. An obvious advantage of n-channel transistor 68 is that only one transistor, not two, is used and thus less layout area is required. However, bootstrapping of the local select signal, $LS_n$, may be required, especially if local bitline are biased at $V_{cc}$ in order to avoid a $V_T$ drop across n-channel transistor 68. It may be possible to obviate the need for bootstrapping if n-channel transistor 68 has a natural $V_T$ (without implant) of 0.3. volts rather than a normal $V_T$ of approximately 0.65 volts and an n-channel pullup is used on the local bitline. Additionally, utilizing a pumped well in order to reduce body effect may also make bootstrapping unnecessary. It will be understood by one skilled in the art that, while a pumped well and a natural $V_T$ are not necessary, they are enhancements that may or may not be made.

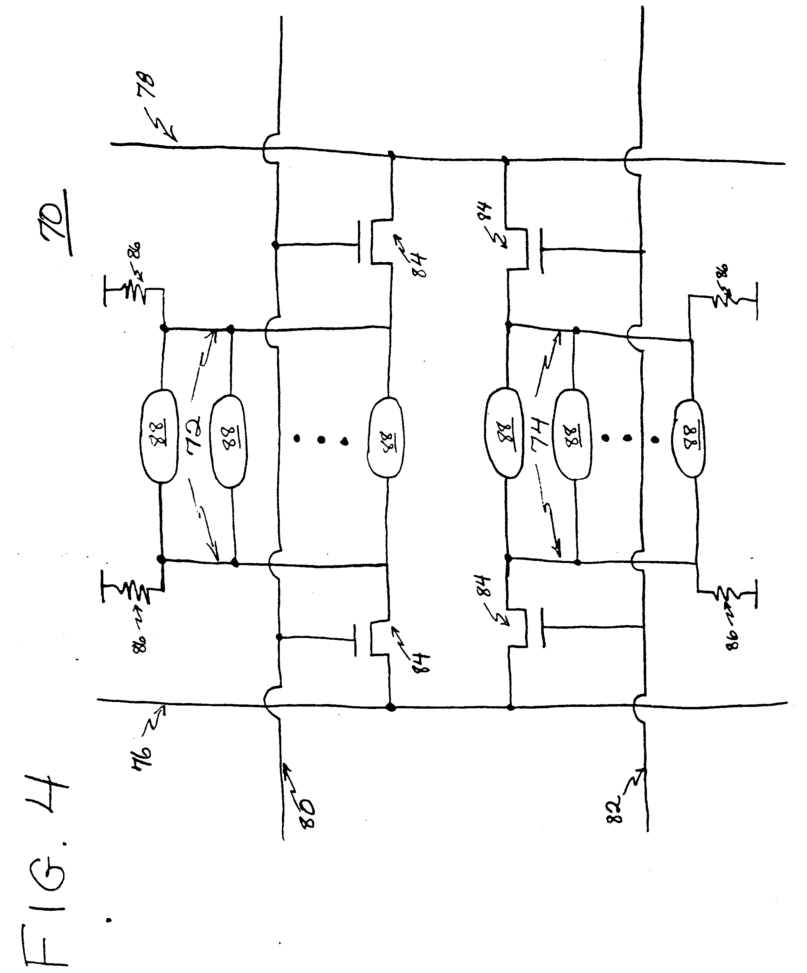

Referring now to Figure 4, shown is a schematic diagram of a partitioned memory array 70 having n-channel transistor interface circuitry 84 and local bitline high value resistors 86 such that local bitlines do not float. . For simplicity, only two of the four local bitlines required for the 4 Megabit example are shown: local bitline pairs 72 and 74. Local bitline pairs 72 and 74 have high value resistors 86 which tie the local bitline pair to $V_{cc}$ such that it does not float. A typical value for high value resistor 86 is 1 Megohm. The local bitline pairs are connected to master bitline 76 and master bitline 78 by n-channel transistors 84, comprising the interface circuitry 84. Local select signals 80 and 82 couple local bitlines 72 and 74, respectively, to master bitline 76 and master bitline 78. The use of n-channel transistor interface circuitry 84 and resistive load 86 greatly decreases the level of bitline capacitance which must be driven by memory cells 88 and ties the local bitlines to a predetermined voltage.

The recovery of local bitlines through precharge and/or equilibrate can be accomplished by leaving local select signals on while the master bitline pair is being recovered. If required, local bitline pairs could have their own equilibrate and/or precharge devices, such as a p-channel or other shorting transistor, where equilibrate is decoded based on local select signals. In addition, on a synchronous or pipelined device, multiple wordlines associated with different local bitlines could be selected at the same time, if advantageous. This would allow independent development of signals on each local bitline, where the clocking of local select signals are performed at the appropriate time. This would, of course, increase the power consumption level. However, if signal swing on the local bitlines is reduced, equilibrate and/or precharge may be avoided entirely, except at the end of a write cycle. Thus, circuitry needed for equilibrate and/or precharge functions would be reduced or eliminated.

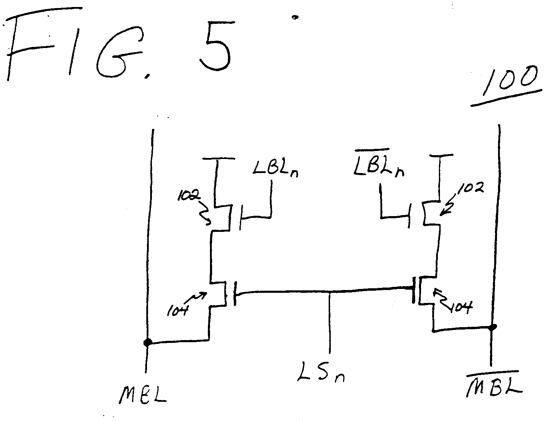

Interface circuitry may be implemented a variety of ways but it must allow for the reading and writing of memory cells. Additionally, it is desirable to explore interface circuitry options which provide voltage gain and/or isolation while connecting local bitlines to master bitlines. **Figures** 5-18, schematic diagrams illustrating alternate preferred embodiments of interface circuitry necessary for performing a read, according to the present invention, are shown.

Referring now to **Figure** 5 interface circuitry 100 is shown. Local bitline pair $LBL_n$ and $\overline{LBL_n}$ are connected to master bitline pair MBL and $\overline{MBL}$ via source follower transistors 102 and select transistors 104. While the select transistors 104 are shown as n-channel devices, they could also be p-channel transistors. The local select signal $LS_n$ is used to select one local bitline pair to control the master bitline pair. This option works particularly well when local bitlines are biased at $V_{cc}$. Source follower transistors 102 are advantageous in that they provide a shifting mechanism for MBL and $\overline{MBL}$ which allows an optimum common mode voltage for sensing MBL and $\overline{MBL}$ to be provided. Master bitline pair MBL and $\overline{MBL}$ are then sensed by a separate sense amplifier.

The gain provided by source follower transistors 102 may be close to unity, depending on the master bitline load used, but a high current drive or transconductance may be instead achieved, which is desirable when driving large capacitances. Unlike interface circuitry for a passive hierarchical bitline structure, interface circuitry for an active hierarchical bitline structure is comprised of active components which amplify the local bitline voltage or current differential developed by the selected memory cell. In addition, the local bitline capacitance is isolated from the master bitline capacitance. Thus, the local bitline capacitance is basically the only capacitance the memory cell must drive. Also, unlike the prior art where SRAMS typically have passgates in the column decode path, the local bitline signal does not go through passgates which can retard signal development.

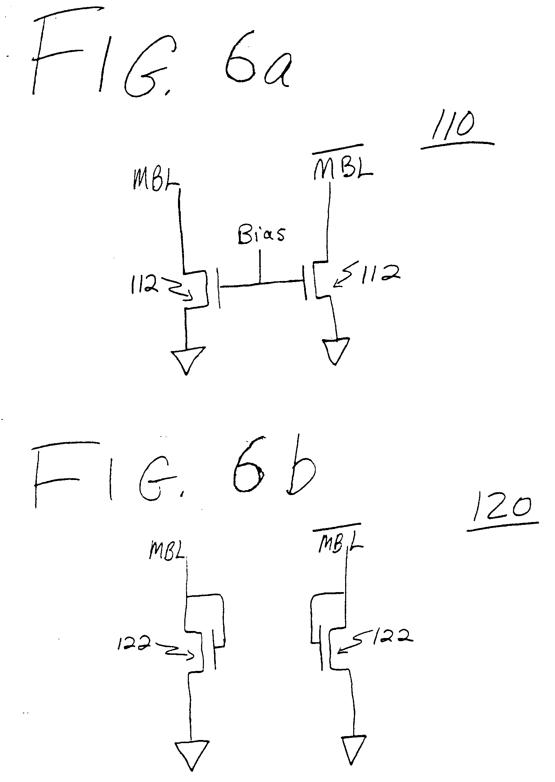

A variety of master bitline load devices exists for hierarchical bitline structures. **Figures** 6a-6d illustrate load devices which offer varying degrees of gain which may be achieved. These load devices may be controlled by a column decode signal. Referring to Figure 5a, the master bitline pair has as load devices n-channel transistors 112. N-channel transistors 112 are controlled by the Bias signal and are biased at a DC voltage above a threshold voltage level. The Bias signal may be a column decode signal, such that only selected columns draw current. In this way, current and therefore power dissipation is greatly reduced. An additional advantage of load device 110 is that few transistors are used. For simplicity, column decode control circuitry is not shown.

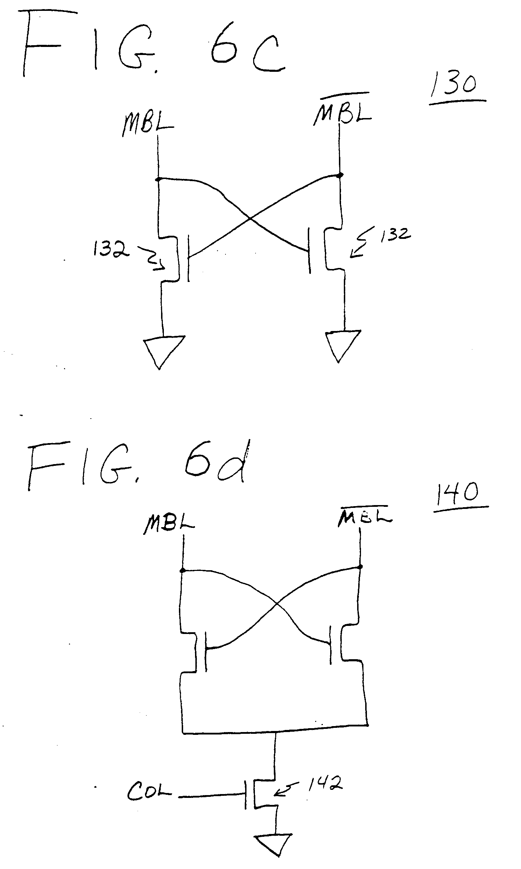

**Figure** 6b illustrates n-channel load transistors 122, the gate of which is tied to the master bitline. Unlike the load device 110 of **Figure** 6a, no biasing is provided and gain may be reduced. Referring to **Figure** 6c, a third type of master bitline loading device 130 is shown. The gates of N-channel load transistors 132 are tied to the opposite master bitline as shown. This configuration offers greater gain than the load devices of **Figures** 6a and 6b, but does introduce feedback which may result in varying degrees of device latching. Referring to **Figure** 6d, a similar load device 140 with column decode control is shown. MBL and $\overline{MBL}$ are tied to n-channel transistor 142 which has column decode signal COL has its gate input.

While the master bitline load devices of **Figures** 6a-6d are described in conjunction with the interface circuitry of **Figure** 5, it will be understood by one skilled in the art that these load devices are equally well suited for other interface circuitry options, such as those which will now be described. An advantage of the load devices of **Figures** 6a-6d is that they have only a small number of transistors, effectively allowing for a smaller layout area.

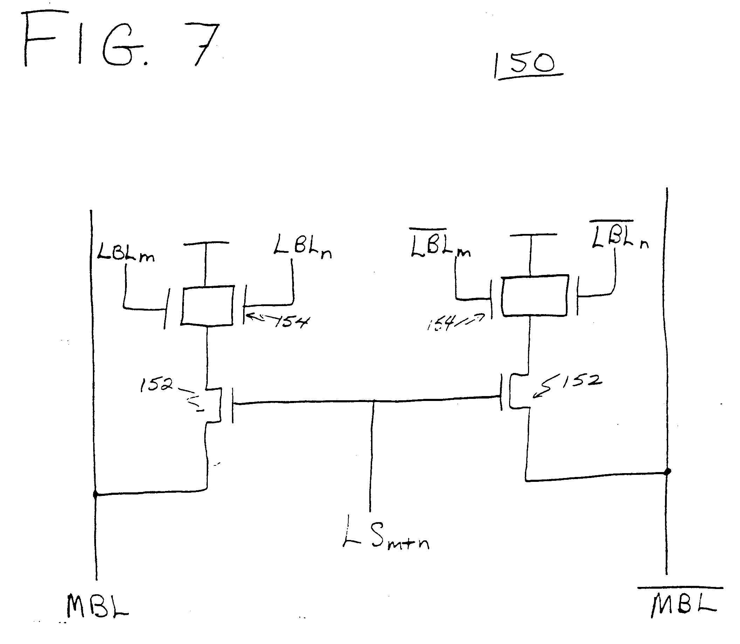

The circuitry 150 of **Figure** 7 connects two different local bitlines $LBL_m$ and $LBL_n$ to master bitline pair MBL and $\overline{MBL}$ by combining interface circuitry. Adjacent interface circuitry, n-channel transistors 152, is utilized to minimize transistor count. Even though both local bitline $LBL_m$ and local bitline $LBL_n$ will affect master bitline pair MBL and $\overline{MBL}$ at the same time, only column m or n will have a voltage differential from the supply voltage, which is typically 5 volts. Therefore, the current differential of n-channel source follower transistors 154 is comparable to that of source-follower transistors 102 of **Figure** 5. However, the current differential expressed as a percent of total source-follower current is half that of **Figure** 5.

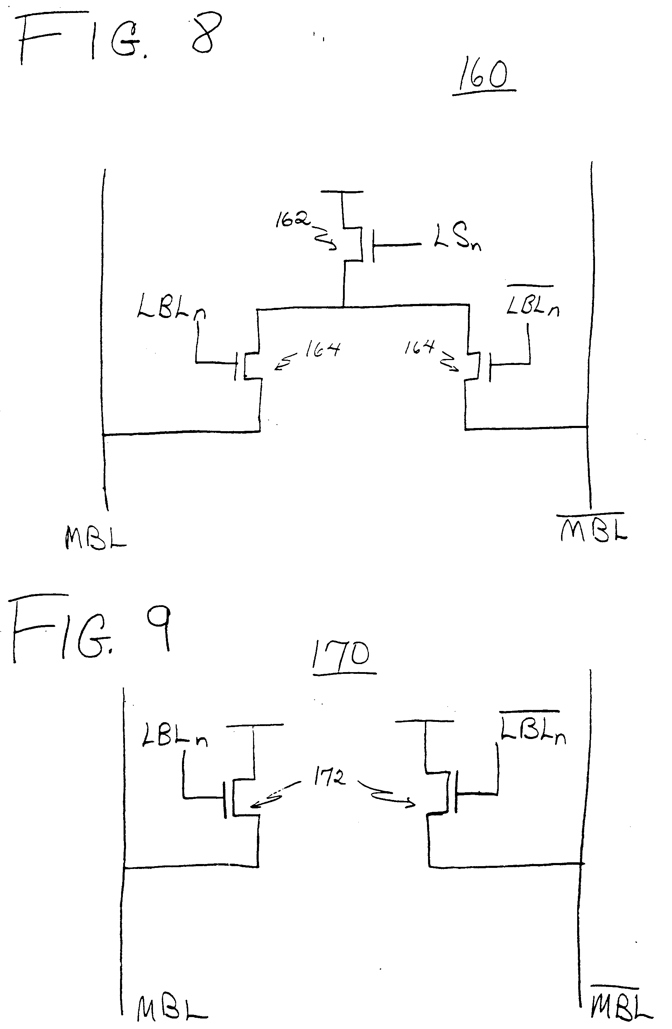

Interface circuitry 160 of **Figure** 8 uses one less transistor than circuitry 100 of **Figure** 5-Two select transistors have been replaced by n-channel select transistor 162, the gate of which is connected to local select signal $LS_n$. Select transistor 162 and source-follower transistors 164 are n-channel, but may also be p-channel transistors. Master bitline pair MBL and $\overline{MBL}$ may get clamped by unselected local bitline transistors, depending on the voltage of the master bitline pair.

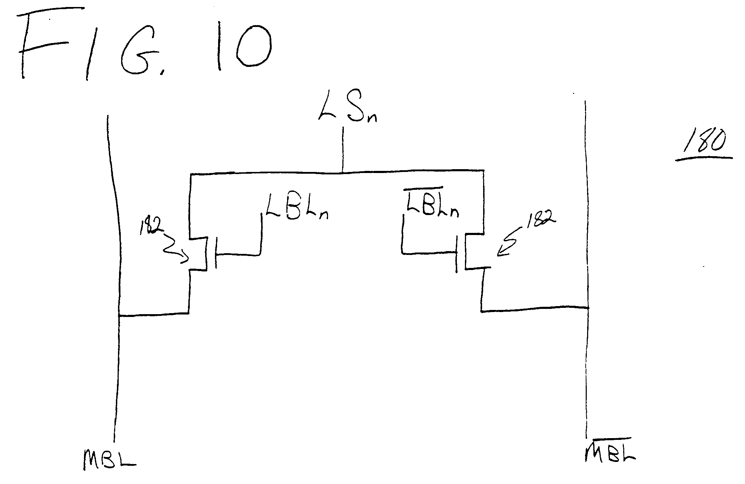

**Figure** 9 illustrates interface circuitry 170 in which only one local bitline will have a voltage differential from the supply voltage. This is similar to the voltage differential discussed in **Figure** 7. Again, only one local bitline will have a voltage differential, and the total current differential on the master bitline pair caused by source follower transistors 172 is due to the resultant voltage differential when a memory cell is selected. The differential expressed as a percentage of total current may be reduced depending on the number of local bitline segments that exist. Thus, the percentage may be lower than that possible with the **Figure** 7 option. Additionally, during write cycles, source follower transistors 172 must be weak enough to be initially overcome; in the other interface circuitry option previously discussed, it is permissible to have the transistors turned off during a write cycle. A advantage of interface circuitry 170 is the small number of transistors required.

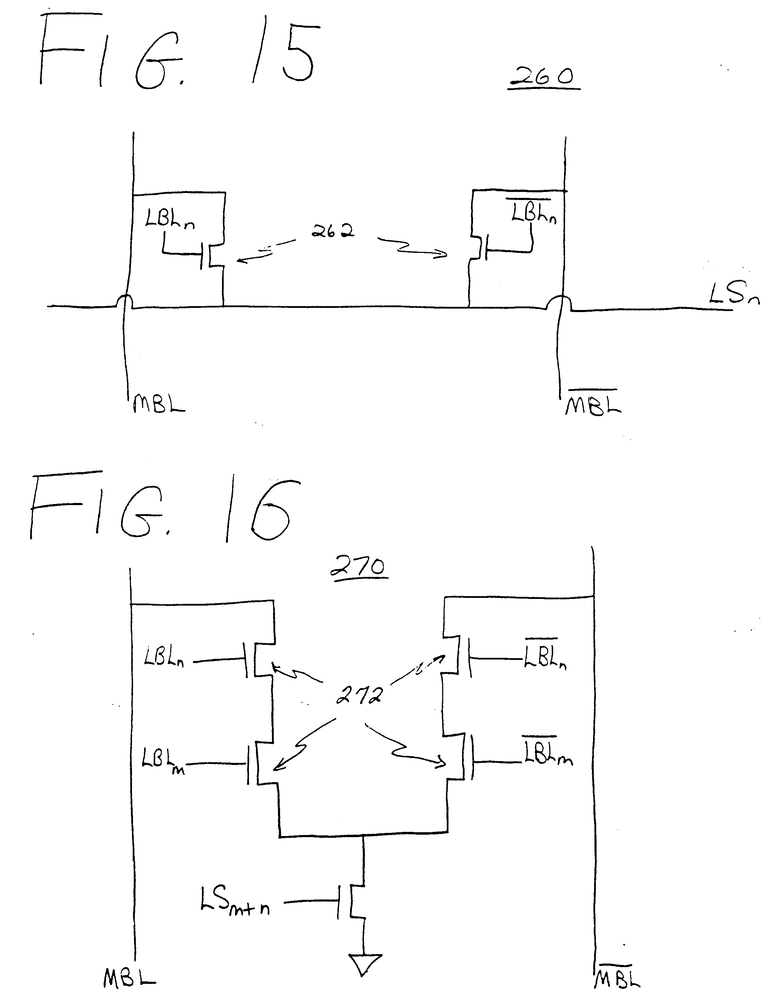

A major advantage of the interface circuitry 180 of **Figure** 15 is that local bitline pairs, such as $LBL_n$ and $\overline{LBL_n}$, which are not selected by local select signal $LS_n$ are not isolated from the master bitline pair MBL and $\overline{MBL}$ but instead form the loads for the master bitline pair. The drain of local bitline transistors 182 are clocked. A local bitline is selected when local select signal LS is high and is deselected when it is low.

Because local bitline transistors 182 act as master bitline loading devices when deselected, the load devices described in **Figures** 6a-6d are not necessary for interface circuitry 180. A disadvantage to this approach is that the current drawn through the loading devices is not controlled by column decoding or any other signal.

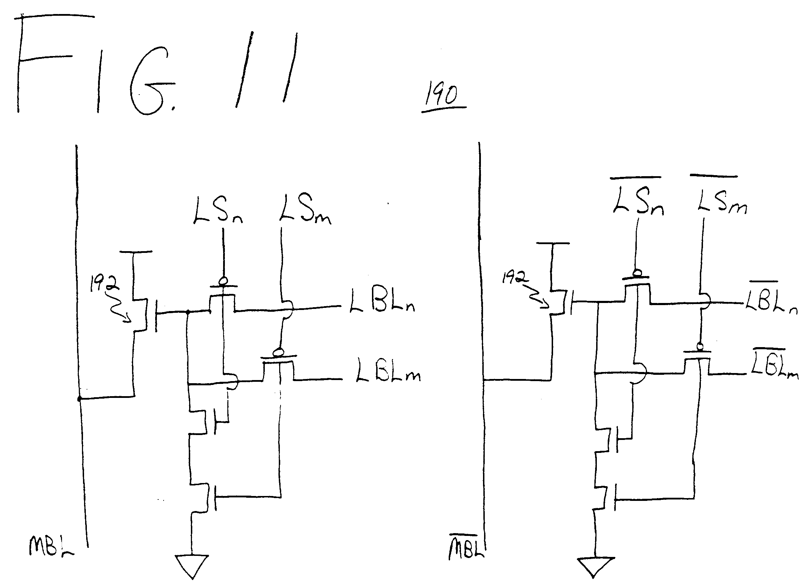

Referring to **Figure** 11, another interface circuitry option 190 is shown. As in **Figure** 7, interface circuitry is combined for two adjacent local bitline pair segments: $LBL_m$ and $LBL_n$. This approach results in fewer transistors being used than if the two adjacent local bitline pair segments did not share interface circuitry. Master bitline pair MBL and $\overline{MBL}$ has no series devices on source follower transistors 192, but the memory cell sees a pass gate. When selecting a local bitline, the appropriate local select signal goes to a logic low voltage level.

For the interface circuitry 200 shown in **Figure** 12, it is necessary for the local bitline pair $LBL_n$ and $\overline{LBL_n}$ to be biased below $V_{cc} - |V_{Tp}|$, such as $V_{cc} - V_{Tn-body}$. The sources of local bitline p-channel transistors 202 are clocked such that the selected local bitline segment has local select signal LS high and the deselected local bitline segment has local select signal LS low. In other words, as long as the master bitline pair is biased below $V_{cc} - V_{Tn-body} + |V_{Tp-body}|$ and $V_{Tn-body} > |V_{Tp}|$, the unselected segments will be isolated from the master bitline pair. Also, as long as the master bitline pair is biased at or below $V_{cc} - [V_{Tn-body} - V_{Tp}]$, p-channel local bitline transistors 202 will be in saturation. For the above equations, $V_{cc}$ is the supply voltage, $V_{Tp-body}$ and $V_{Tn-body}$ are the body effect threshold voltages of p-channel and n-channel transistors, respectively.

In **Figure** 12, p-channel transistors and biasing of local bitlines at $V_{cc} - V_{Tn-body}$ are described and can be used with any other interface circuitry explored in Figures 2 through 10 above.

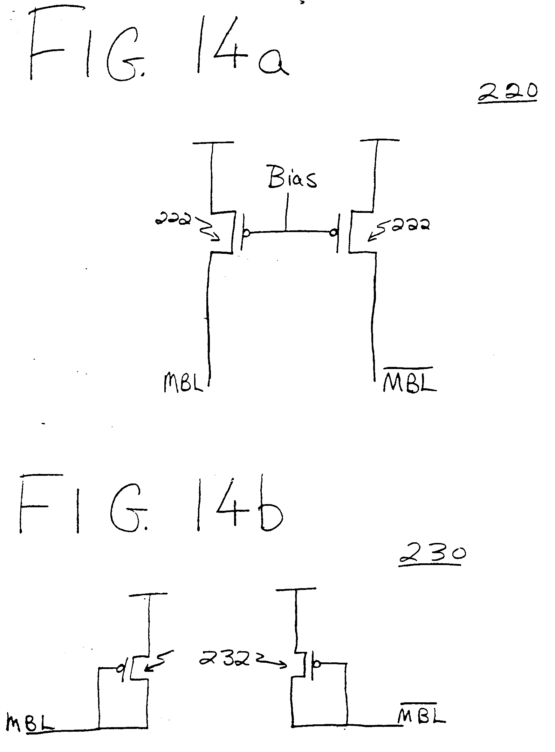

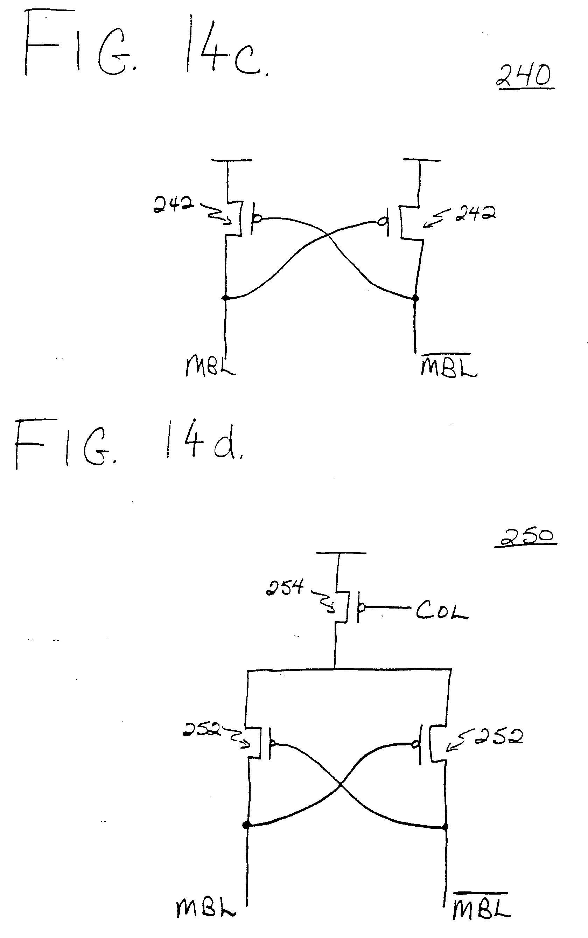

The interface circuitry described above has been biased at a supply voltage such as $V_{cc}$ or $V_{cc}$-$V_T$. It is also possible to have circuitry which is tied to ground. Referring to **Figure 12**, interface circuitry 210 connects local bitline pair $LBL_n$ and $LBL_n$ to master bitline pair MBL and MBL but is biased to ground as shown. Source coupled n-channel transistors 212 are used to interface local bitlines to the master bitline; local bitline pair $LBL_n$ and $LBL_n$ is selected when $LS_n$ is a logic high voltage level. Local bitlines may be biased at $V_{cc} - V_{Tn}$ with the master bitline load devices, examples shown in **Figure** 14, such as high value resistors or p-channel transistors, connected to $V_{cc}$.

Referring to **Figures** 14a-14d several different master bitline loading devices are shown. As in **Figures** 6a-6d these load devices may easily be controlled by a column decode signal such that only selected columns would draw current, thereby reducing current and power consumption. Referring to **Figure** 14a, the master bitline pair has as load devices p-channel transistors 222. P-channel transistors 222 are controlled by the Bias signal and are biased at a DC voltage below $V_{cc} - |V_{Tp}|$. The Bias signal may be a column decode signal, such that only selected columns draw current. The Bias signal is a logic high voltage level when the column is unselected. In this way, current and therefore power dissipation is greatly reduced. An additional advantage of load device 220 is that few transistors are used. For simplicity, column decode control circuitry is not shown.

**Figure** 14b illustrates p-channel load transistors 232, the gate of which is tied to the master bitline. Unlike the circuitry 220 of **Figure** 14a, no biasing is provided and gain may be relatively small. Referring to **Figure** 14c, a third type of master bitline loading device 240 is shown. The gates of p-channel load transistors 242 are tied to the opposite master bitline as shown. This configuration offers greater gain than the load devices of **Figures** 14a-14b, but also introduces feedback which may result in varying degrees of device latching. Referring to **Figure** 14d, a similar load device 250 with column decode control is shown. P-channel transistor 254 has column decode signal COL as its gate input. Resistors, biased to $V_{cc}$, could also be used as master bitline load devices.

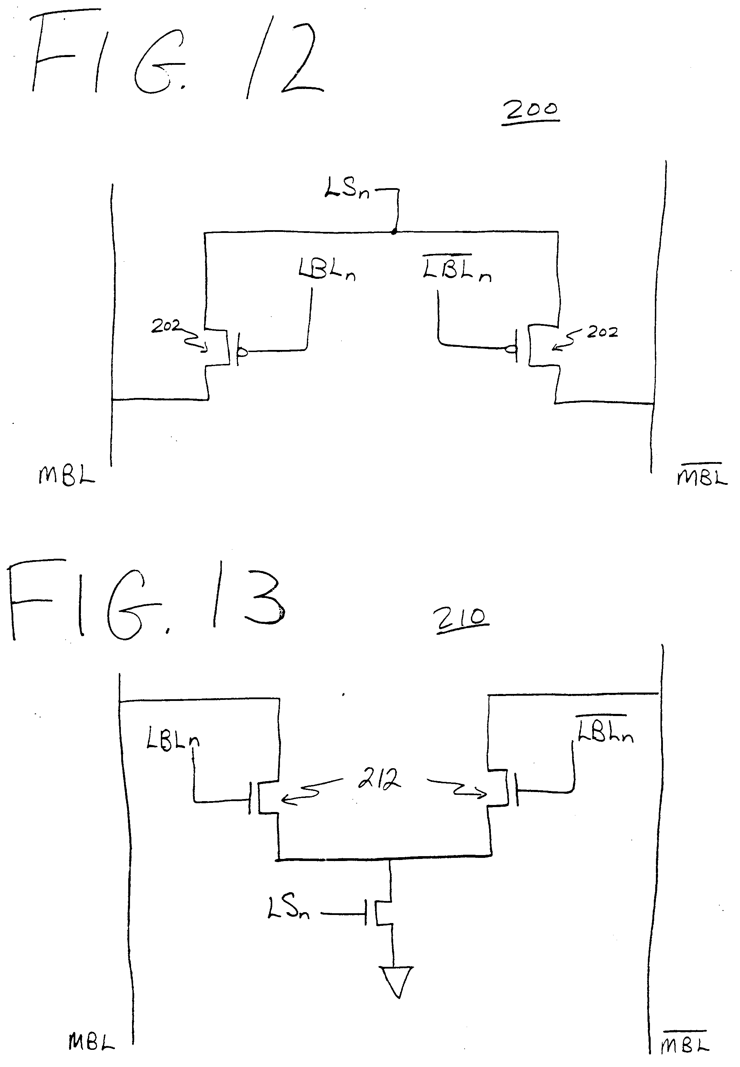

While the master bitline load devices of **Figures** 14a-14d are described in conjunction with the interface circuitry of **Figure** 13, it will be understood by one skilled in the art that these load devices are equally well suited for other interface circuitry options, such as those which will now be described.

Referring to **Figure** 13,the current source transistor used in other interface circuits is not included to minimize transistors used. Instead the local select signal $LS_n$, which is clocked to ground, acts as a current source. Local bitline pair $LBL_n$ and $\overline{LBL_n}$ are connected to local bitline transistors 262 which are connected to master bitline pair MBL and $\overline{MBL}$. An advantage of this interface circuitry is that the transistor count is low.

**Figure** 15 illustrates interface circuitry 270 which is similar to that shown in **Figure** 13 but that adjacent local bitline segments combine interface circuitry in order to save on transistor count. Interface circuitry 270 connects local bitline pairs $LBL_n$, $\overline{LBL_n}$, $LBL_m$, and $\overline{LBL_m}$ to master bitline pair MBL and $\overline{MBL}$ but is biased to ground as shown. N-channel transistors 272 are used to interface local bitlines to the master bitline. While transistors 272 are connected serially, they may also be placed in parallel to each other. Local bitlines may be biased at $V_{cc}$ - $V_{Tn}$ with the master bitline loads such as high value resistors or p-channel transistors, connected to $V_{cc}$.

Local bitline segments which are not selected by local select signal $LS_{m+n}$ will have no differential voltage from ground, such that the differential voltage on the master bitline pair will be due to the differential which exists at the local bitline pair which is selected.

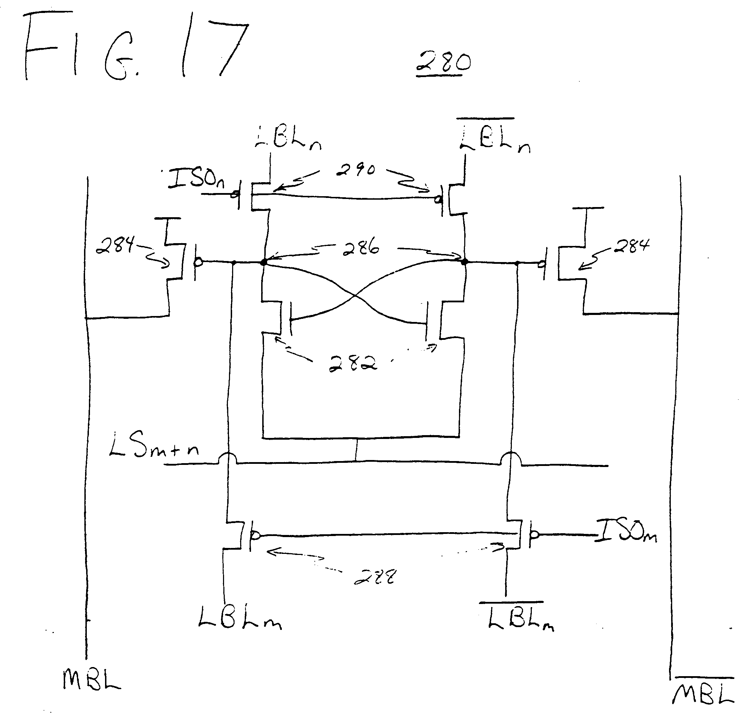

Referring to the interface circuit 280 of **Figure** 17, adjacent local bitline segments $LBL_m$ and $LBL_n$ share a dynamic sense amp, comprised of n-channel transistors 282, clocked by local select signal $LS_{m+n}$. Again, the sharing of interface circuitry allows transistor count to be minimized. Also, having one local select signal $LS_{m+n}$ means less signals are needed. P-channel transistors 284 may be replaced by n-channel devices if sense nodes 286 are inverted.

Isolation input signals $ISO_m$ and $ISO_n$ allow local bitline $LBL_m$ or $LBL_n$ to be isolated. By setting $ISO_m$ to a logic high voltage level such as 5 volts, local bitline pair $LBL_m$ and $\overline{LBL_m}$ are effectively isolated from other device circuitry; similarly, when $ISO_n$ is set to a logic low voltage level such as 0 volts, local bitline pair $LBL_n$ and $\overline{LBL_n}$ are not isolated from the dynamic sense amplifier. For example, $LS_{m+n}$ is clocked low to sense data and $ISO_n$ is then clocked high to isolate the sense amplifier from local bitline $LBL_n$.

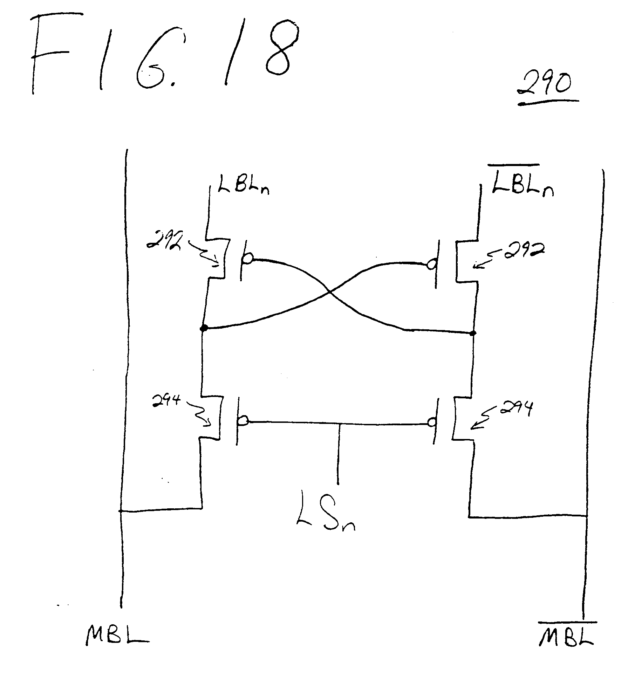

Finally, **Figure** 18 illustrates interface circuitry 290 which employs a cascode current sense amp to provide a virtual short across local bitline pair $LBL_n$ and $\overline{LBL_n}$ if p-channel transistors 292 are biased properly, i.e. at saturation. Thus, the current difference between the series paths formed by p-channel transistors 292 and 294 is the memory cell current. As with other interface circuits, various load devices, such as those shown in **Figures** 6a-6d may be utilized.

In addition to the interface circuitry discussed in **Figure** 18 it is possible to use other forms of cascade and/or cascode voltage and current sensing to achieve voltage gain. Another option which may enhance manufacturability is to lay interface circuitry out on multiple column pitch with multiple local select signals decoded by column addresses.

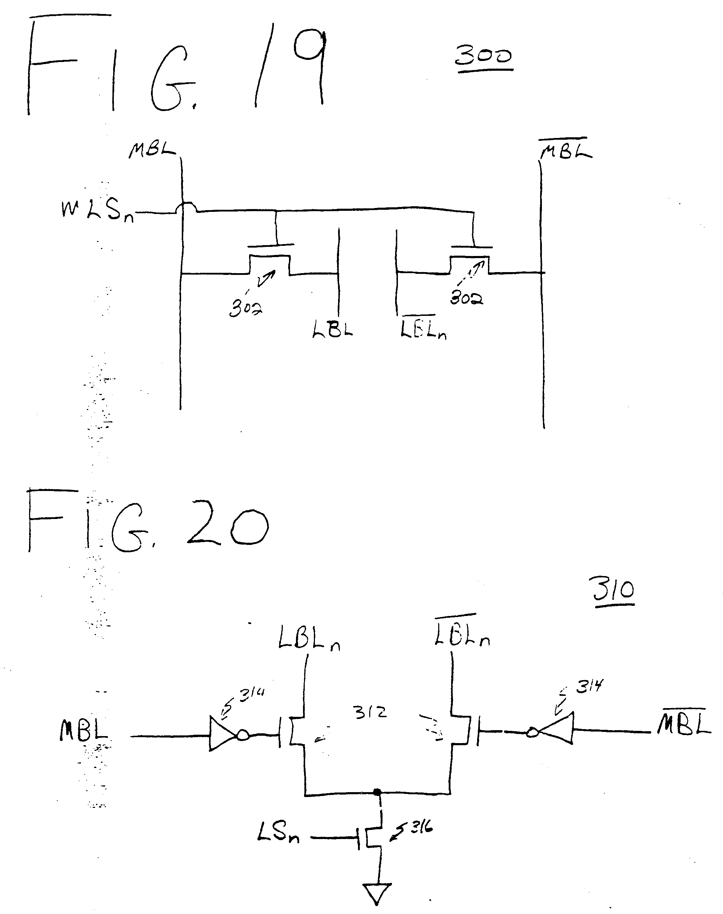

Up to now, the interface circuitry options discussed have been suitable for performing a read, but have not provided connection between the master bitline pair and local bitline pairs suitable for performing a write. Referring to write circuitry 300 of **Figure** 19, n-channel passgate 302 conducts only during a write cycle. Write local select signal $WLS_n$ will go to a logic high voltage level only during a write cycle and only if the row address points to a row associated with that particular local bitline, in this case $LBL_n$. A memory cell is written by driving the appropriate master bitline pair low and turning on the write local select n-channel transistors 302 such that the local bitline may be pulled to a low logic level.

As mentioned previously, recovery through precharging of the local bitlines may be achieved by precharing the master bitline pair and pulsing the write local select signal $WLS_n$ to connect the local bitline pair to its associated master bitline pair. Also, it may be necessary to have an equilibrate device on the local bitline pair in order to short together the two local bitlines comprising a bitline pair: for instance, $LBL_n$ and $\overline{LBL_n}$. If any equilibrate signal is required, it could be decoded using a local select signal.

Local bitlines which are not selected during a write cycle can not be allowed to float for an indefinite period of time. As mentioned earlier, a pull-up transistor or high value resistor may be required for each local bitline. For instance, an interface circuitry option calling for biasing of the local bitlines to $V_{cc}$ - $V_T$ may utilize a high value resistor which is also connected to a $V_{cc}$ - $V_T$ level. Alternately, if a pull-up transistor which is strong enough to clamp the local bitline voltage differential to a small value is used, recovery of the line through equilibration may not be required between read cycles even though recovery may be required after a write cycle.

Another option for write circuitry is shown in **Figure** 20. Local bitline transistors 312 control local bitline pair $LBL_n$ and $\overline{LBL_n}$. Circuitry 310 performs such that the master bitline pair is at or near $V_{cc}$ during a read cycle. However, during a write cycle, inverters 314 cause either LBL or $\overline{LBL}$ to be pulled to ground through local select transistor 316 based on either MBL or $\overline{MBL}$ being at ground. An advantage of this circuitry over that of **Figure** 19 is that a separate write local select signal $WLS_n$ is not required.

The hierarchical bitline memory architecture described above is useful for asynchronous, synchronous and pipelined memory devices such as SRAMs, DRAMs, EPROMs and EEPROMs. It is particularly useful on high density, high performance devices such as the 4 Megabit SRAM, 16 Megabit SRAM and larger devices, to reduce the effective bitline capacitance a memory cell must drive. The speed advantage which could be realized with the hierarchical memory architecture would depend on the density of the device and the number of partitions of the bitline into local bitlines (at the expense of area) but could be on the order of several nanoseconds. The ability to choose various kinds of interface circuitry for use in hierarchical bitline memory architecture allows for the control of characteristics such as voltage gain and/or isolation. Control of these characteristics allows for an active hierarchical bitline memory architecture. control of characteristics such as voltage gain and/or isolation. Control of these characteristics allows for an active hierarchical bitline memory architecture.

While the invention has been particularly shown and described with reference to a preferred embodiment, it will be understood by those skilled in the art that various changes in form and detail may be made therein without departing from the spirit and scope of the invention. For instance, local bitline pairs have been described in conjunction with the 4 Megabit SRAM embodiment, but one skilled in the art will appreciate that while other high density memories such as DRAMs, EPROMs, and EEPROMs have bitlines, not bitline pairs, the spirit and scope of the invention will not be affected. Additionally, the placement of the master bitlines in the third metal layer and local bitlines in the second metal layer is only one possible way to implement device metallization. Also, master and sub-master wordlines, master bitlines, and local bitlines could be placed in any conductive material such as metal or polysilicon.

## Claims

1. A partitioned memory array, comprising:

    a plurality of master bitlines;

    a plurality of local bitlines connected to a plurality of memory cells;

    a plurality of interface circuits, which connects each master bitline to at least two of the local bitlines; and

    a plurality of local select signals, each capable of selecting a corresponding local bitline to be coupled to its corresponding master bitline.

2. The memory array of claim 1, wherein each local select signal controls one interface circuit for each master bitline.

3. The memory array of claim 1, wherein the interface circuitry is comprised of an n-channel transistor.

4. The memory array of claim 3, wherein the local select signals are bootstrapped above a first supply voltage.

5. The memory array of claim 3, wherein the n-channel transistor has a lower $V_T$ such that the voltage drop across it is minimised.

6. The memory array of claim 3, wherein the well in which the n-channel transistor resides is pumped to a lower voltage which is less than a second supply voltage.

7. The memory array of claim 1, wherein each local bitline is connected to a loading element such that it is tied to a predetermined voltage level.

8. A partitioned memory array, comprising:

    a plurality of master bitlines;

    a plurality of local bitlines connected to a plurality of memory cells;

    a plurality of interface circuits, which connects each master bitline to at least two of the local bitlines and which provides for gain of a signal on the local bitlines or isolation of the capacitance of the local bitlines from the capacitance of the master bitlines; and

    a plurality of local select signals, each capable of selecting a corresponding local bitline to be coupled to its corresponding master bitline.

9. The memory array of claim 8, wherein the local bitline is connected to the master bitline through at least one select transistor and isolation of the capacitance of the local bitlines from the capacitance of the master bitlines is provided by at least one source-follower transistor.

10. The memory array of claim 9, wherein the source of an n-channel select transistor is connected to the master bitline, the gate is connected to a corresponding local select signal, and the drain is connected to an n-channel source follower transistor whose drain is connected to a supply voltage and whose gate is connected to the local bitline.

11. The memory array of claim 9, wherein the drain of a p-channel select transistor is connected to the master bitline, the gate is connected to a corresponding local select signal, and the source is connected to an n-channel source follower transistor whose drain is connected to a supply voltage and whose gate is connected to the local bitline.

12. The memory array of claim 8, wherein the interface circuit of a local bitline which is not selected to be coupled to its corresponding master bitline acts as a load device for its corresponding master bitline.

13. The memory array of claim 8, wherein at least two local bitlines share a dynamic sense amp, share a local select signal which clocks the dynamic sense amp, with each local bitline having an isolate signal to isolate the capacitance of the local bitline from the capacitance of the master bitline, and wherein the dynamic sense amp controls transistors connected to the master bitline.

14. The memory array of claim 8, wherein the memory array is formed using a first metal layer, a second metal layer, and a third metal layer.

15. The memory array of claim 1 or claim 8, wherein one of the local bitlines may be recovered when its local select signal is selected while its corresponding master bitline is being recovered.

16. The memory array of claim 1 or claim 8, wherein each local bitline has a precharge device which is controlled by a precharge signal.

17. The memory array of claim 8, wherein the master bitlines each have a load device which is connected to a supply voltage.

10
512 rows
512 rows
12
14
16
18
4096 Columns

FIG. 1
(prior art)

20
22
24
26
28
30
32
34
36
38
40
50
52

FIG. 2

FIG. 3
a)
60
LBL
64
62
LSn
LSn
MBL
b)
66
LBL
68
LSn
MBL

FIG. 4
70
76
78
80
82
84
84
84
84
86
86
86
86
72
74
88
88
88
88
88
88

FIG. 5
100
LBLn
LBLn
102
102
104
104
LSn
MBL
MBL

FIG. 6a
110
MBL
MBL
Bias
112
112
FIG. 6b
120
MBL
MBL
122
122

FIG. 6C
130
MBL
$\overline{MBL}$
132
132

FIG. 6d
140
MBL
$\overline{MBL}$
COL
142

FIG. 7

150
$LBL_m$
$LBL_n$
$\overline{LBL_m}$
$\overline{LBL_n}$
154
154
152
152
$LS_{m+n}$
MBL
$\overline{MBL}$

FIG. 8

160

162
$LS_n$
$LBL_n$
$\overline{LBL_n}$
164
164
MBL
$\overline{MBL}$

FIG. 9

170

$LBL_n$

$\overline{LBL_n}$

172

MBL

$\overline{MBL}$

FIG. 10
$LS_n$
180
$LBL_n$
$\overline{LBL_n}$
182
182
MBL
$\overline{MBL}$

FIG. 11
190
192
LSn
LSm
LBLn
LBLm
MBL
192
LSn
LSm
LBLn
LBLm
MBL

FIG. 12
200
$LS_n$
$LBL_n$
$\overline{LBL_n}$
202
202
MBL
$\overline{MBL}$
FIG. 13
210
$LBL_n$
$\overline{LBL_n}$
212
$LS_n$
MBL
$\overline{MBL}$

FIG. 14a
220
Bias
222
222
MBL
MBL
FIG. 14b
230
232
MBL
MBL

FIG. 14c.

240
242
242
MBL
$\overline{MBL}$

FIG. 14d.

250
254
COL
252
252
MBL
$\overline{MBL}$

FIG. 15
260
LBLn
262
LBLn
LSn
MBL
MBL
FIG. 16
270
LBLn
272
LBLn
LBLm
LBLm
LSm+n
MBL
MBL

FIG. 17
280
LBLn
LBLn
ISOn
290
284
286
284
282
LSm+n
ISOm
288
LBLm
LBLm
MBL
MBL

FIG. 18
290
$LBL_n$
$\overline{LBL_n}$
292
292
294
294
$LS_n$
MBL
$\overline{MBL}$

FIG. 19
300
MBL
$\overline{MBL}$
WLSn
302
302
LBL
$\overline{LBL_n}$
FIG. 20
310
LBLn
$\overline{LBL_n}$
314
314
312
MBL
$\overline{MBL}$
LSn
316